# EUROPEAN PATENT APPLICATION

(11) **EP 2 037 579 A2**
(43) Date of publication of application: **18.03.2009**
(21) Application number: 08380267.8
(22) Date of filing: 12.09.2008
(51) Int. Cl.: H03J 1/00

(54) **Remote control system for domestic appliances**

(30) Priority: 13.09.2007 ES 200701874 U
(71) Applicant: Fagor, S. Coop., 20500 Mondragon (Gipuzkoa) (ES)
(72) Inventor: Garate Orbe, Alfonso, 48015 Bilbao (Bizkaia) (ES); Errasti Erlogorri, Natividad, 20550 Aretxabaleta (Gipuzkoa) (ES)
(74) Representative: Igartua, Ismael

(57) **Abstract**

Remote control system for domestic appliances, comprising a mobile remote control device (1) suitable for receiving instructions from a user, and at least one fixed device (2) connected to at least one domestic appliance (A₁,A₂,A₃,A₄..Aₙ) and that communicates with said mobile device (1). The mobile device (1) receives voice instructions and comprises a microphone (4) that converts the voice instructions into an electrical signal, and a voice recognition unit (5) that converts said electrical signal into a recognisable code that is transmitted to the fixed device (2). The mobile device (1) comprises a bracelet (6) to be worn by the user and which incorporates the microphone (4), the voice recognition unit (5) and the bidirectional communication means (3a) of the mobile device (1).

## Description

### TECHNICAL FIELD

The present invention relates to a remote control system for domestic appliances.

### PRIOR ART

Remote control systems for controlling electronic appliances or equipment from a distance are known in the prior art. Said systems comprise a mobile remote control device that is linked to a fixed device connected to the appliance or equipment to be controlled. The mobile device and the fixed device are connected by wireless communication, eg by radiofrequency, infrared light etc. Said communication between the remote control device and the fixed device may be unidirectional or bidirectional.

Remote control devices applied to domestic appliances are known.

WO 01/71685 A1 discloses a remote control system for domestic appliances, which comprises a mobile remote control device suitable for receiving instructions from a user, and a plurality of fixed devices, each fixed device being connected to a domestic appliance. Said mobile device and said fixed devices comprise bidirectional communication means that enable the exchange of information by radiofrequency between the mobile device and the fixed devices.

### DISCLOSURE OF THE INVENTION

It is the object of this invention to provide a remote control system for domestic appliances as defined in the claims.

The remote control system of the invention comprises a mobile remote control device suitable for receiving instructions from a user, and at least one fixed device connected to at least one domestic appliance. Said mobile device and said fixed device comprise bidirectional communication means that enable the exchange of information between the mobile device and the fixed device. The mobile device receives the instructions orally and comprises a microphone that converts the voice instructions into an electrical signal, and a voice recognition unit that converts said electrical signal into a recognisable code that is transmitted to the fixed device. The mobile device comprises a bracelet to be worn by the user and which incorporates the microphone, the voice recognition unit and the bidirectional communication means of the mobile device.

The remote control system of the invention provides the user with the option of controlling domestic appliances from anywhere in the home.

On the other hand, given that the voice recognition unit is incorporated into the mobile device, the information transmitted by the mobile device to the fixed device is digital, as a result of which there is less risk of interference and, therefore, greater reliability in the transmission of instructions.

In addition, the mobile remote control device possesses construction and functional characteristics that improve certain ergonomic aspects and make it easier to use, which means that it may be used by people with a physical handicap or people who would otherwise have difficulties in operating it.

These and other advantages and characteristics of the invention will be made evident in the light of the drawings and the detailed description thereof.

### DESCRIPTION OF THE DRAWINGS

Figure 1 shows a schematic view of the remote control system for domestic appliances of the invention, showing the mobile device connected to the fixed device, the latter being connected to several domestic appliances.
Figure 2 shows a block diagram of the remote control system of Figure 1.

### DETAILED DISCLOSURE OF THE INVENTION

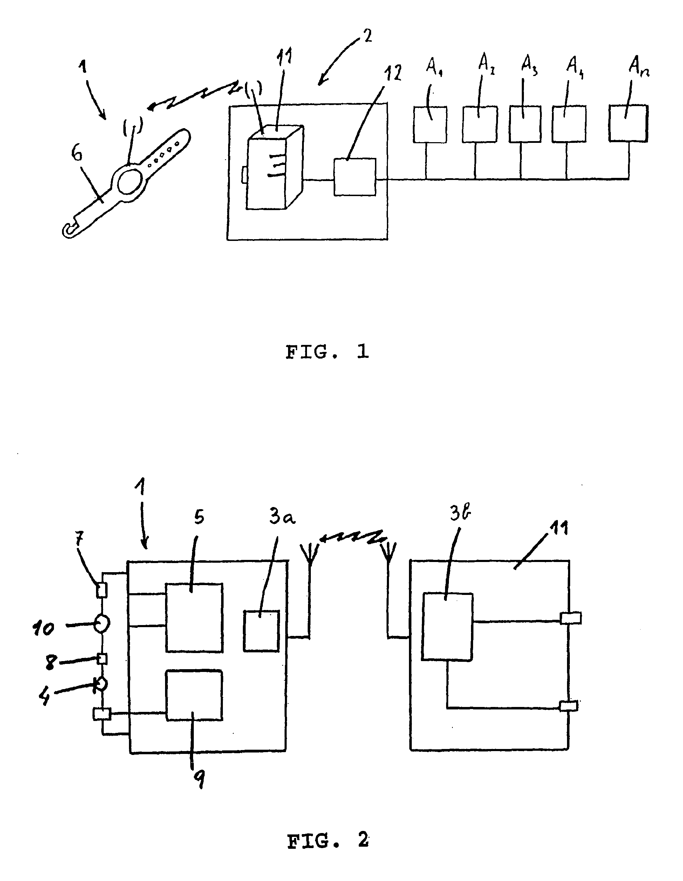

As shown in the embodiment of Figure 1, the remote control system of the invention comprises a mobile device 1 suitable for receiving instructions from a user and a fixed device 2 that is connected to several domestic appliances A₁,A₂,A₃,A₄..Aₙ in a home, eg a washing machine, dishwasher, oven, cooker, refrigerator etc. The mobile device 1 controls said domestic appliances A₁,A₂,A₃,A₄..Aₙ through the fixed device 2.

Said mobile device 1 and said fixed device 2 comprise, as shown in Figure 2, bidirectional communication means 3a, 3b that enable the exchange of information between the mobile device 1 and the fixed device 2.

The exchange of information between the mobile device 1 and the fixed device 2 is preferably performed by radiofrequency, therefore having a greater radius of action in relation to other types of communication such as via infrared light or ultrasound etc, all of which enables the user to control the domestic appliances A₁,A₂,A₃,A₄..Aₙ from anywhere in the home.

The mobile device 1 transmits action commands and enquiries on the status of the domestic appliances A₁,A₂,A₃,A₄..Aₙ to said domestic appliances A₁,A₂,A₃,A₄..Aₙ through the fixed device 2, and said fixed device 2 transmits to the user any notifications of incompatibility between said action commands and the actual status of the domestic appliances A₁,A₂,A₃,A₄..Aₙ, as well as notifications of alarms, such as water leaks, gas leaks, power cuts etc in the domestic appliances A₁,A₂,A₃,A₄..Aₙ through the mobile device 1.

The mobile device 1 of the remote control system of the invention receives voice instructions, as a result of which said mobile device 1, in addition to said bidirectional communication means 3a, comprises, as shown in Figure 2, a microphone 4 that converts the voice instructions into an electrical signal, and a voice recognition unit 5 connected to said microphone 4, which converts said electrical signal into a recognisable code that is transmitted to the fixed device 2. The fact that the voice recognition unit 5 is incorporated into the mobile device 1 in such a way that said mobile device 1 transmits a code rather than a voice signal makes the transmission between the mobile device 1 and the fixed device 2 more reliable. In addition, said transmission is quicker and its consumption is reduced.

As shown in Figure 1, the mobile device 1 comprises a bracelet 6 that may be attached to the user's wrist and which incorporates the microphone 4, the voice recognition unit 5 and the bidirectional communication means 3a of the mobile device 1.

The voice recognition unit 5 converts the electrical signal corresponding to a voice instruction into a piece of master data. Said voice recognition unit 5 comprises a memory, not shown in the figures, that comprises a plurality of master data corresponding to the voice instructions, and comparison means, not shown in the figures, that compare the piece of master data corresponding to said electrical signal with each of said pieces of master data in the memory, thereby producing a code corresponding to the voice instruction.

As shown in Figure 2, the mobile device 1 comprises a switch 7, the activation of which activates communication between the user and the mobile device 1, and between the mobile device 1 and the fixed device 2. The activation of said switch 7 also activates the voice recognition process of the voice recognition unit 5, as a result of which the latter is prevented from being continually active.

Furthermore, the mobile device 1 comprises a speaker 8, said mobile device 1 communicating with the user through voice menus. Said speaker 8 transmits affirmatives, status enquiries and alarms to the user. For this purpose the voice recognition unit 5 comprises voice synthesis means, not shown in the figures, which reproduce a series of pre-recorded messages.

The bidirectional communication means 3a, 3b of the mobile device 1 and the fixed device 2 comprise a transceiver.

The mobile device 1 comprises a supply system based on a rechargeable battery 9, which requires an external charger, not shown in the figures. In addition, the fixed device 2 comprises a continuous mains power supply.

The mobile device 1 also comprises an indicator light 10 that informs the user of specific situations such as the need to recharge the battery, alerts etc. Said indicator light 10 comprises a LED.

The construction and functional characteristics of the mobile device 1 improve certain ergonomic aspects and make it easier to use, which means that it may be used by people with a physical handicap or people who would otherwise have difficulties in operating it.

The remote control system comprises a single fixed device 2 that controls all the domestic appliances A₁,A₂,A₃,A₄..Aₙ in a centralised manner. Said fixed device 2 is housed in the home's power distribution box, not shown in the figures, which is usually situated in the entrance hall.

Said fixed device 2 comprises a communication module 11 and a control module 12. The communication module 11 transmits the recognisable codes to the control module 12 by means of communication based on a specific protocol, and the latter controls the domestic appliances A₁,A₂,A₃,A₄..Aₙ.

As well as controlling domestic appliances A₁,A₂,A₃,A₄..Aₙ the remote control system of the invention may also be used to control automatisms, not shown in the figures.

## Claims

1. Remote control system for domestic appliances, comprising a mobile remote control device (1) suitable for receiving instructions from a user, and at least one fixed device (2) connected to at least one domestic appliance (A₁,A₂,A₃,A₄..Aₙ), said mobile device (1) and said fixed device (2) comprising bidirectional communication means (3a, 3b) that enable the exchange of information between the mobile device (1) and the fixed device (2), **characterised in that** the mobile device (1) receives voice instructions and comprises a microphone (4) that converts the voice instructions into an electrical signal, and a voice recognition unit (5) that converts said electrical signal into a recognisable code that is transmitted to the fixed device (2), the mobile device (1) comprising a bracelet (6) to be worn by the user and which incorporates the microphone (4), the voice recognition unit (5) and the bidirectional communication means (3a) of the mobile device (1).

2. Remote control system according to claim 1, wherein the exchange of information between the mobile device (1) and the fixed device (2) is performed by radiofrequency.

3. Remote control system according to any of the preceding claims, wherein the voice recognition unit (5) converts the electrical signal corresponding to a voice instruction into a piece of master data, said voice recognition unit (5) comprising a memory that comprises a plurality of master data corresponding to the voice instructions, and comparison means that compare the piece of master data corresponding to said electrical signal with each of said pieces of master data in the memory for producing a code corresponding to the voice instruction.

4. Remote control system according to any of the preceding claims, wherein the mobile device (1) comprises a switch (7), the activation of which activates communication between the user and the mobile device (1), and between the mobile device (1) and the fixed device (2).

5. Remote control system according to the preceding claim, wherein the activation of the switch (7) activates the voice recognition process of the voice recognition unit (5).

6. Remote control system according to any of the preceding claims, wherein the mobile device (1) comprises a speaker (8), said mobile device (1) communicating with the user through voice menus.

7. Remote control system according to any of the preceding claims, wherein the bidirectional communication means (3a, 3b) of the mobile device (1) and of the fixed device (2) comprise a transceiver.

8. Remote control system according to any of the preceding claims, comprising a single fixed device (2) that controls all the domestic appliances (A₁,A₂,A₃,A₄..Aₙ) in a centralised manner.
